(19) Europäisches Patentamt
European Patent Office
Office européen des brevets

(11) **EP 3 787 164 A1**

(12) **EUROPEAN PATENT APPLICATION**
published in accordance with Art. 153(4) EPC

(43) Date of publication:
**03.03.2021 Bulletin 2021/09**

(21) Application number: **19792293.3**

(22) Date of filing: **11.03.2019**

(51) Int Cl.:
**H02M 1/08** (2006.01)    **H03K 17/08** (2006.01)
**H03K 17/0812** (2006.01)

(86) International application number:
**PCT/JP2019/009651**

(87) International publication number:
**WO 2019/207977 (31.10.2019 Gazette 2019/44)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **24.04.2018 JP 2018082704**

(71) Applicant: **Hitachi, Ltd.**
**Tokyo 100-8280 (JP)**

(72) Inventors:
• **SUZUKI, Hiroshi**
**Tokyo 100-8280 (JP)**
• **KURIHARA, Naoki**
**Tokyo 100-8280 (JP)**

(74) Representative: **Mewburn Ellis LLP**
**Aurora Building**
**Counterslip**
**Bristol BS1 6BX (GB)**

(54) **GATE DRIVE CIRCUIT AND GATE DRIVE METHOD**

(57)    The purpose of the present invention relates to suppressing the fluctuation of gate-source voltage in a gate drive circuit using SiC voltage-driven semiconductor elements. In order to achieve this purpose, according to the present invention, the gate drive circuit is configured such that: a P-type MOSFET and an N-side MOSFET are connected in series and the N-side MOSFET is directly connected to a negative side power supply; and an output stage lying in between the P-type MOSFET and the N-side MOSFET is negatively biased while a SiC voltage-driven semiconductor element is OFF. According to the present invention, since the output stage is constituted by a MOSFET having a small transient impedance, it is possible to suppress the fluctuation of gate-source voltage when driving the SiC voltage-driven semiconductor element. Since the gate is negatively biased while the SiC voltage-driven semiconductor element is OFF, it is possible to prevent erroneous ON. Accordingly, it is possible to provide a highly reliable gate drive circuit suitable for driving a SiC element.

FIG. 2

**Description**

TECHNICAL FIELD

The present invention relates to a gate drive circuit for a voltage-driven semiconductor device using SiC, for example, an SiC-MOSFET.

BACKGROUND ART

IGBTs (Insulated Gate Bipolar Transistors) capable of highspeed switching and controlling large power are widely used ranging in applications from small-capacity inverters for home use to large-capacity inverters for railway use. As circuits for driving voltage-driven semiconductor devices such as IGBTs, gate drive circuits such as gate drivers which control turning on/off of semiconductor devices by controlling the voltage applied to gates are used. In recent years, inverters using, instead of IGBTs using Si, MOSFETs (Metal-Oxide-Semiconductor Field Effect Transistors) using low-loss SiC are becoming popular, and, in railway applications, too, gate drivers suitable for driving SiC-MOSFETs are in demand.

CITATION LIST

Patent Literature

Patent literature 1: Japanese Unexamined Patent Application Publication No. 2012-9962
Patent literature 2: Japanese Unexamined Patent Application Publication No. 2014-57491

SUMMARY OF INVENTION

Technical Problem

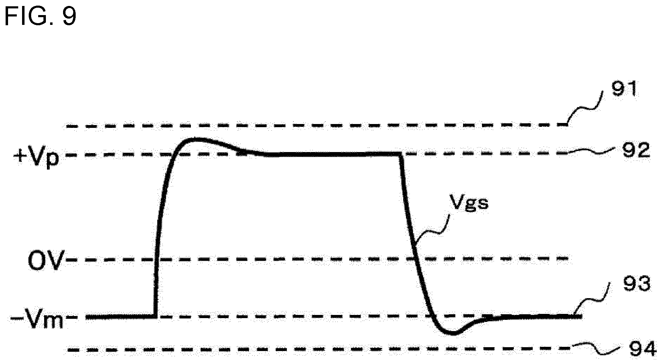

The present inventors have come to acquire the following findings as a result of earnestly studying gate drive circuits for driving voltage-driven semiconductor devices using SiC, for example, SiC-MOSFETs.
As a characteristic of voltage-driven semiconductor devices using SiC, for example, SiC-MOSFETs, it has been found that their resistance to electric field stress applied to their gates are, in the present state, lower than that of Si-IGBTs. For example, like Si-IGBTs, SiC-MOSFETs also use silicon dioxide film ($SiO_2$) as a gate oxide film material, but, due to defects attributable to the production process and substrate material used, SiC devices, compared with Si devices, show more remarkable device characteristic variations when their gates are subjected to electric field stress. Therefore, when the gate driver output voltage exceeds the rated gate-source voltage of a semiconductor device, the gate-source voltage of a semiconductor device connected to the gate driver also exceeds the rated voltage, and this causes concern about device characteristic variations and deterioration of gate oxide film reliability. Hence, it is desirable that the output voltage of the gate driver remains stable without reaching the rated gate-source voltage of the semiconductor device.
As another characteristic, SiC-MOSFETs have a large gate-drain feedback capacitance and a high switching speed (dV/dt). Therefore, there has been a problem that gate-source voltage variations (rising) in a MOSFET can easily cause an erroneous on state. Namely, when a high dV/dt is impressed between the drain and source of a MOSFET, a displacement current (Cgd*dV/dt) via a feedback capacitance flows from the MOSFET side to the gate driver side, and effects of the current flowing through inductance components of the gate wiring and resistance components in the gate drive circuit allow the gate potential of the SiC-MOSFET to rise easily. When, as a result, the gate-source voltage of the SiC-MOSTFET exceeds a threshold value causing an erroneous on state, arms may develop short-circuiting, for example. The reason why the feedback capacitance of SiC-MOSFETs is generally larger than that of Si-IGBTs is that, with SiC-MOSFETs being unipolar devices, they have high substrate doping concentrations which prevent depletion layer widths from expanding easily.
As SiC-MOSFETs have the above-described two characteristics, gate drivers to drive SiC-MOSFETs are desired to have a characteristic to suppress gate-source voltage variations for SiC-MOSFETs.
In cases where, as described in patent literature 1, an SiC-MOSFET is turned on/off using a gate driver having an output stage including a push-pull circuit using bipolar transistors, high transient impedance of the bipolar transistors causes the output voltage of the gate driver to vary beyond the supply voltage of the gate drive circuit and, as a result, the gate-source voltage of the SiC-MOSFET also exceeds the supply voltage. Namely, as shown in Fig. 9, when the MOSFET turns on, an overshoot occurs in which the gate-source voltage (Vgs) transiently exceeds the positive supply voltage

(+Vp) of the gate drive circuit and, when the MOSFET turns off, an undershoot occurs in which the gate-source voltage (Vgs) transiently lowers below the negative supply voltage (-Vp) of the gate drive circuit. Due to this phenomenon, the gate-source voltage of the MOSFET exceeds a rated voltage or the margin provided before the rated voltage is reached reduces to cause a concern from a viewpoint of securing gate oxide film reliability.

Also, when an SiC-MOSFET is turned off, positive dV/dt (>0) is applied to between the drain and the source of the SiC-MOSFET being turned off, whereas negative dV/dt (<0) is applied to the SiC-MOSFET paired with the SiC-MOSFET being turned off. This causes a phenomenon in which the gate-source voltage (Vgs) of the SiC-MOSFET on the paired side lowers below the negative power supply (-Vm) of the gate driver.

According to patent literature 2, an output stage MOSFET is connected, via a diode, to the negative power supply of the gate driver. In such a configuration, however, with the capacitance component of the diode being held between the negative power supply of the gate driver and the gate terminal of the SiC-MOSFET, when Vgs lowers, Vgs of the SiC-MOSFET is not stabilized, so that variation of the gate-source voltage cannot be suppressed.

An object of the present invention concerns suppressing gate-source voltage variation in a gate drive circuit for a voltage-driven semiconductor device using SiC.

Solution to Problem

The present invention relates to a gate drive circuit which includes a P-type MOSFET and an N-type MOSFET being mutually series-connected, the N-type MOSFET being directly connected to a negative power supply and in which an output stage provided between the P-type MOSFET and the N-type MOSFET is negatively biased while a voltage-driven semiconductor device using SiC is off.

Advantageous Effects of Invention

According to the present invention, since an output stage is configured using a MOSFET with a low transient impedance, gate-source voltage variation can be suppressed when driving a voltage-driven semiconductor device using SiC. As a result, while a voltage-driven semiconductor device using SiC is off, its gate is negatively biased, so that the semiconductor device is prevented from being erroneously turned on. Therefore, a highly reliable gate drive circuit suitable for driving a SiC device can be provided.

BRIEF DESCRIPTION OF DRAWINGS

Fig. 1 shows a configuration of a railway inverter system according to a first embodiment.
Fig. 2 shows a configuration of a gate driver according to the first embodiment.
Fig. 3 shows a configuration of a gate driver including a bipolar transistor as an output stage device.
Fig. 4 is a diagram for describing a phenomenon of gate-source voltage rising.
Fig. 5 shows a configuration of a gate driver according to a second embodiment.
Fig. 6 is a diagram for describing a phenomenon of gate-source voltage lowering.
Fig. 7 shows a configuration of a gate driver according to the third embodiment.
Fig. 8 shows a configuration of a gate driver according to the fourth embodiment.
Fig. 9 is a schematic diagram showing a gate-source voltage waveform in a case where a bipolar transistor is used as an output stage device for a gate driver.

DESCRIPTION OF EMBODIMENTS

As an embodiment, a gate drive circuit for driving a voltage-driven semiconductor device using SiC is disclosed, the gate drive circuit including a P-type MOSFET and an N-type MOSFET which are mutually series-connected, the N-type MOSFET being directly connected to a negative power supply. In the gate drive circuit, the P-type MOSFET and the N-type MOSFET are complementarily turned on/off so as to cause an output stage provided between the P-type MOSFET and the N-type MOSFET to be negatively biased while the semiconductor device is off.

Also, as an embodiment, a gate drive method for a voltage-driven semiconductor device using SiC is disclosed, in which a P-type MOSFET and an N-type MOSFET which is directly connected to a negative power supply are complementarily turned on/off so as to negatively bias an output stage provided between the mutually series-connected P-type MOSFET and N-type MOSFET while the semiconductor device is off.

Also, as an embodiment, a gate drive circuit including a voltage keeping means is disclosed, the voltage keeping means keeping an output stage negatively biased while the semiconductor device is off. Also, a gate drive method is disclosed in which the output stage is kept negatively biased by a voltage keeping means while the semiconductor device is off.

Also, as an embodiment, it is disclosed that the voltage keeping means includes a diode connected, in parallel to the N-type MOSFET, between an output part and the negative power supply. It is also disclosed that the diode is a Schottky barrier diode, a Zener diode, or a PN diode.

Also, as an embodiment, a gate drive circuit is disclosed in which the voltage keeping means includes a parallel resistor connected in parallel to an off-side gate resistor provided between the output stage and the N-type MOSFET, a switch series-connected to the parallel resistor and a determination unit which turns the switch on when the semiconductor device is in an off state. Also, a gate drive method is disclosed in which, when the semiconductor device is in an off state, a switch series-connected to a parallel resistor which is parallel-connected to an off-side gate resistor provided between the output stage and the N-type MOSFET is turned on.

Also, as an embodiment, a gate drive circuit is disclosed in which the voltage keeping means includes a MOSFET connected, in parallel to the N-type MOSFET, between the output stage and the negative power supply and a determination unit which causes the MOSFET to be short-circuited when the semiconductor device is in an off-state. Also, a gate drive method is disclosed in which, when the semiconductor device is in an off state, a MOSFET connected, in parallel to the N-type MOSFET, between the output stage and the negative-side power supply is short-circuited.

Also, as an embodiment, it is disclosed that the voltage-driven semiconductor device is a normally-off semiconductor device.

Also, as an embodiment, a gate drive circuit is disclosed in which an insulated power transformer or an insulated DC-DC converter is used for voltage generation for the negative power supply. A gate drive method is also disclosed in which an insulated power transformer or an insulated DC-DC converter is used for voltage generation for the negative power supply.

Also, as an embodiment, a three-phase AC inverter is disclosed which is mounted with a gate drive circuit.

In the following, the above and other novel features and effects of the present invention will be described with reference to drawings.

The drawings are only for understanding the invention and do not reduce the scope of rights.

First Embodiment

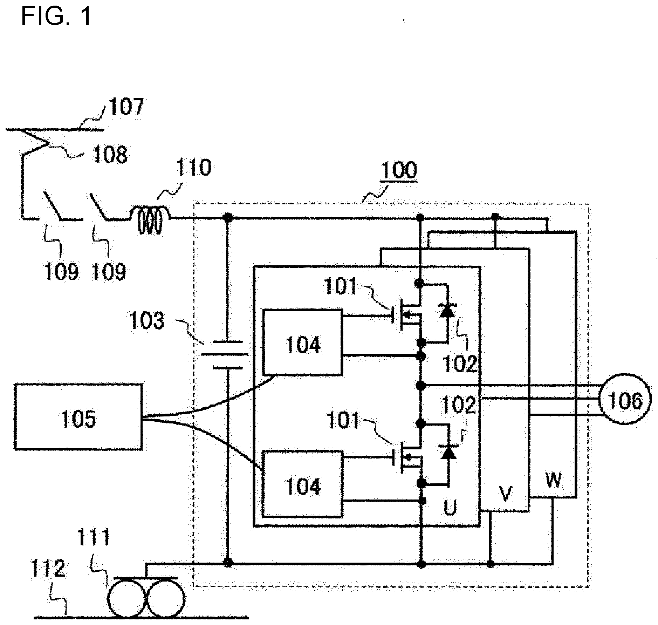

Fig. 1 shows a configuration of a railway inverter system according to the present embodiment.

In the railway inverter system of the present embodiment, a power unit 100 includes voltage-driven semiconductor devices (e.g., IGBTs or MOSFETs) 101 and a filter capacitor 103. For each of the phases U, V and W, MOSFETs 101 are series-connected, and the MOSFETs 101 are each parallel-connected with a freewheel diode 102 so that the current flow directions are opposite between them. Also, each MOSFET 101 is provided with a gate drive circuit 104 for driving the MOSFET in accordance with commands from a command logic unit 105. The connection point between the upper MOSFET (upper arm) and the lower MOSFET (lower arm) for each of the phases U, V and W, is connected as an output of the power unit 100 to a motor 106.

DC power from an overhead contact line 107 is smoothed through a power collector 108, plural breakers 109 and a filter reactor 110, and is then inputted to the high-voltage side of the filter capacitor 103 for noise removal. The low voltage side of the filter capacitor 103 is connected, via a wheel 111, to a rail 112 serving as an electrical ground. The railway inverter system generates, by alternatingly switching the MOSFETs for the U, V and W phases, a three-phase AC current and sends it to the motor 106. The gate drive circuits 104 included, along with the MOSFETs 101 and the filter capacitor 103, in the power unit 100, drive the MOSFETs 101 in accordance with commands from the command logic unit 105. The command logic unit 105 includes a calculation unit, memory and input/output means and outputs, in accordance with a predetermined program, commands for driving the MOSFETs. Note that the gate drive circuit according to the present embodiment will be described based on an example case of driving MOSFETs as semiconductor devices, but the semiconductor devices are not limited to MOSFETs and may be other voltage-driven devices, for example, IGBTs.

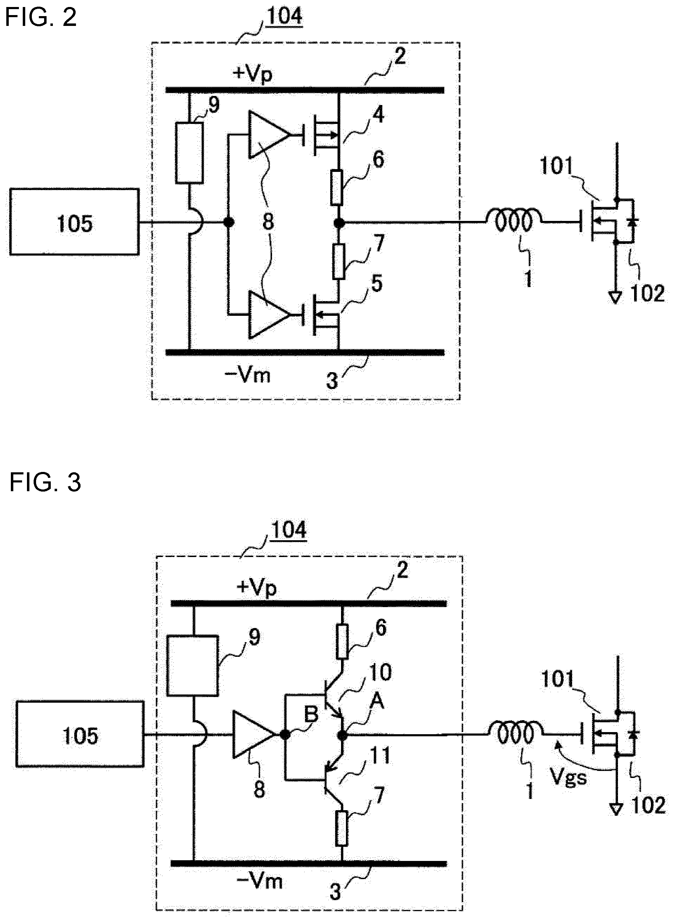

Fig. 2 shows a configuration of the gate drive circuit of the present embodiment. As shown in Fig. 2, the gate drive circuit 104 has a push-pull configuration using a complementary pair of MOSFETs and includes a positive power supply 2, a negative power supply 3, a P-type MOSFET 4, an N-type MOSFET 5, an on-side gate resistor 6, an off-side gate resistor 7, a drive control device 8, and a power generation unit 9. The power generation unit 9 is connected to the positive power supply 2 and the negative power supply 3. The source of the P-type MOSFET 4 is connected to the positive power supply 2 and the drain is connected to the on-side gate resistor 6. The source of the N-type MOSFET 5 is connected to the negative power supply 3 and the drain is connected to the off-side gate resistor 7. In this configuration, the source of the N-type MOSFET 5 and the negative power supply 3 are preferably directly connected as shown in Fig. 2. The connection point between the on-side gate resistor 6 and the off-side gate resistor 7 is an output part of the gate drive circuit 104 and is connected to the gate of a semiconductor device 101 via a gate wiring 1. The gates of the P-type MOSFET 4 and N-type MOSFET 5 are respectively connected to output parts of the drive control device 8. Input parts of the drive control device 8 are connected to the command logic unit 105.

The power generation unit 9 supplies positive and negative voltages to the positive power supply 2 and negative power supply 3, respectively. When a gate drive command is received from the command logic unit 105, the drive control device 8, by controlling the P-type MOSFET 4 and N-type MOSFET 5 in the output stage of the gate drive circuit in a manner of complementarily turning them on and off, charges or discharges the gate of the semiconductor device 101 via the gate wiring 1. The speed of charging and discharging can be controlled by the on-side gate resistor 6 and the off-side gate resistor 7, respectively.

Fig. 3 is a configuration diagram showing, for comparison with the present embodiment, a gate drive circuit corresponding to the gate drive circuit shown in Fig. 2 but with the output stage including bipolar transistors (NPN transistor 10 and PNP transistor 11) instead of the MOSFETs (P-type MOSFET 4 and N-type MOSFET 5).

The collector of the NPN transistor 10 is connected to the positive power supply 2 via the on-side gate resistor 6. The collector of the PNP transistor 11 is connected to the negative power supply 3 via the off-side gate resistor 7. The emitters of the NPN transistor 10 and PNP transistor 11 are mutually connected at point A shown in FIG. 3, making up an output part of the gate drive circuit 104 connected to the gate of the semiconductor device 101 via the gate wiring 1. The bases of the NPN transistor 10 and PNP transistor 11 are both connected to the output part of the drive control device 8. In other respects of connections, Fig. 3 is the same as Fig. 2.

As shown in Fig. 3, in cases where the gate drive circuit has an output stage configured with bipolar transistors, when the drive control device 8 performs control to complementarily turn the NPN transistor 10 and PNP transistor 11 on and off, a period inevitably occurs during which the NPN transistor 10 and the PNP transistor 11 simultaneously turn off. This is because, an operation point inevitably occurs at which the output part (point B in Fig. 3) of the drive control device 8 assumes such a potential at which the base-emitter voltage of neither the NPN transistor 10 and the PNP transistor 11 is forward biased. At such a time, current does not easily flow through the path leading from the output part (point A in Fig. 3) of the gate drive circuit to the semiconductor device 101 and a state of high impedance is transitionally generated. This causes the output voltage of the gate drive circuit 104 and also the gate voltage of the semiconductor device 101 to vary exceeding the supply voltages (+Vp, -Vm in Fig. 3) of the gate drive circuit. Namely, when the semiconductor device 101 is on, overshooting (Vgs > +Vp) occurs in which the gate-source voltage (Vgs) transitionally exceeds the supply voltage of the gate drive circuit and, when the semiconductor device 101 is off, undershooting (Vgs < -Vm) occurs (see Fig. 9).

This phenomenon of the gate-source voltage of the semiconductor device 101 varying exceeding the supply voltage can be suppressed by configuring the output stage of the gate drive circuit with MOSFETs as shown in Fig. 2. This is because bipolar transistors are controlled by current injection, so that, NPN and PNP transistors to be turned on/off require certain amounts of time before their bases are adequately charged; whereas MOSFETs being controlled by voltage impression can turn on/off intrinsically quickly, so that their gate potentials are stable without entering a transitional high-impedance state as described above.

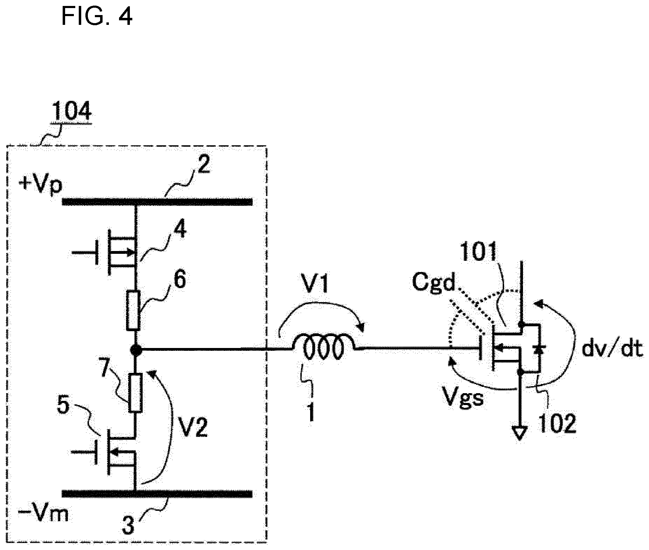

Next, a phenomenon of gate voltage rising will be described. Fig. 4 is a diagram for describing the phenomenon of gate-source voltage rising. As shown in Fig. 4, when the semiconductor device on the paired arm side (i.e., on the upper-arm side in a case where the semiconductor device 101 shown in Fig. 4 is a lower-arm MOSFET) turns on, the semiconductor device 101 is in an off state and a parallel-connected freewheel diode 102 performs reverse recovery operation. At this time, the drain-source voltage of the semiconductor device 101 increases generating a state of (dv/de > 0), so that a displacement current (Cgd*dv/dt) flows from the semiconductor device 101 toward the gate drive circuit 104. In the above expression, dv/dt represents the time rate of change of the drain-source voltage and Cgd represents the gate-drain capacitance (feedback capacitance) of the semiconductor device 101.

The displacement current flows, via the semiconductor device 101, gate wiring 1, off-side gate resistor 7, and N-type MOSFET 5, into the negative power supply 3 of the gate drive circuit. At this time, as shown in Fig. 4, a potential difference dependent on the circuit impedance of the current path occurs between the gate terminal of the semiconductor device 101 and the negative power supply 3 of the gate drive circuit. Therefore, the gate-source voltage (Vgs) of the semiconductor device 101 rises to be higher by the potential difference than the voltage (-Vm) of the negative power supply 3 of the gate drive circuit. Namely, a potential difference of V1 + V2 occurs as represented by (Equation 1), where V1 is a potential difference attributable to the parasitic inductance of the gate wiring 1, and V2 is a potential difference attributable to the off-side gate resistor 7 and the parasitic resistance of the N-type

MOSFET 5.

$$Vgs = -Vm + (V1 + V2) \qquad Equation\ 1$$

When the above-described rising of the gate voltage causes Vgs of the semiconductor device 101 to exceed the corresponding threshold voltage (Vth) and an erroneous on state to occur, arm short-circuiting may occur.

Generally, in railway applications, a normally-off device is used as the semiconductor device 101. Therefore, when the device is off, no problem is caused in terms of operation principle even with Vgs being 0 V. In the present embodiment, however, with the negative power supply 3 provided in the gate drive circuit, Vgs is, in an off state, set to be negative (for example, Vgs = -10 V). This enlarges the potential difference margin allowable, even when the gate voltage rises in an off state, before Vth is reached and, thereby, prevents occurrence of an erroneous on state. Even in cases where a normally-on device is used as the semiconductor device 101, occurrence of an erroneous on state can be prevented by setting a negative bias voltage such that, even when the gate voltage rises in an off state, Vgs does not reach Vth.

As a method of generating a negative supply voltage, for example, an isolated power transformer is used as the power generation unit 9 shown in Fig. 2. Namely, two sets of winding coils are provided on the secondary side, and the turns ratios of the two sets of coils are designed as one being for positive supply voltage (+Vp) generation and the other being for negative supply voltage (-Vm) generation. Or, positive and negative supply voltages may be generated using an insulated DC-DC converter instead of an insulated power transformer.

Second Embodiment

The second embodiment differs in gate drive circuit configuration from the first embodiment in that a means is provided to, when the gate terminal potential of the semiconductor device lowers, connect the gate potential to the negative power supply of the gate drive circuit. In the following, the second embodiment will be described centering on its differences from the first embodiment.

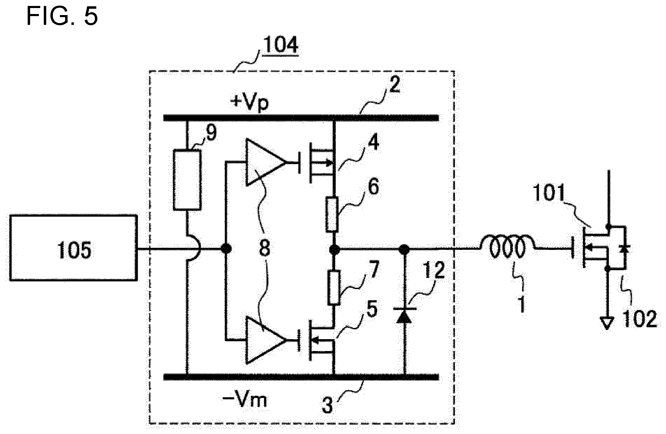

Fig. 5 shows a gate drive circuit configuration according to the present embodiment. The output part of the gate drive circuit 104, i.e., the connection point between the on-side gate resistor 6 and the off-side gate resistor 7, is connected with the cathode of a diode 12. The anode of the diode 12 is connected to the negative power supply 3 of the gate drive circuit. In other respects of connections, the present embodiment is the same as the first embodiment.

With the diode 12 provided, when the gate terminal potential of the semiconductor device 101 lowers, the output part of the gate drive circuit 104 is connected with a low impedance to the negative power supply 3 of the gate drive circuit, so that the gate voltage variation (lowering) can be suppressed.

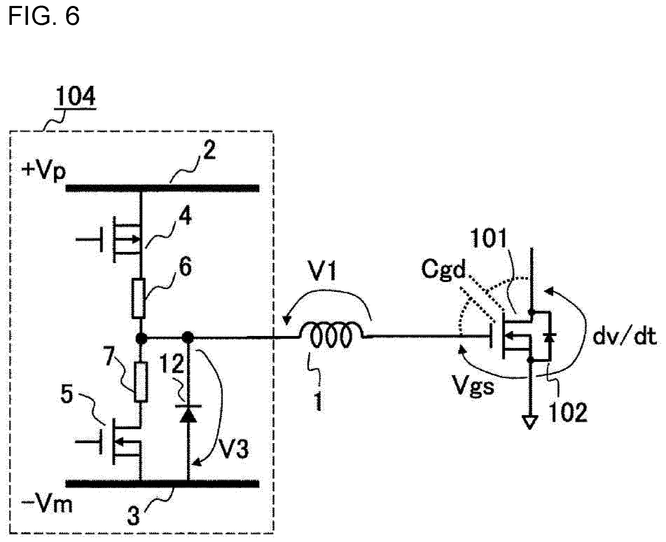

Fig. 6 is a diagram for describing a phenomenon of gate voltage lowering. As shown in Fig. 6, when the semiconductor device on the paired arm side turns off, the semiconductor device 101 is in an off state and the parallel-connected freewheel diode 102 performs forward recovery operation. At this time, the drain-source voltage of the semiconductor 101 decreases, so that, with (dv/dt < 0), a displacement current (Cgd*dv/dt) flows from the gate drive circuit 104 toward the semiconductor device 101.

The displacement current flows, via the negative power supply 3, diode 12 and gate wiring 1 of the gate drive circuit, into the semiconductor device 101. At this time, as shown in Fig. 6, a potential difference dependent on the circuit impedance of the current path occurs between the gate terminal of the semiconductor device 101 and the negative power supply 3 of the gate drive circuit and causes Vgs of the semiconductor device 101 to lower below the voltage (-Vm) of the negative power supply 3 of the gate drive circuit. Namely, as represented by Equation 2, a potential difference of (V1 + V3) occurs, where V3 is a potential difference attributable to the conduction of the diode 12 and equals the forward voltage of the diode 12.

$$\mathrm{Vgs} = -\mathrm{Vm} - (\mathrm{V1} + \mathrm{V3}) \qquad \text{Equation 2}$$

When the phenomenon of gate voltage lowering causes Vgs of the semiconductor device 101 to lower below a lower-limit rated voltage (for example, -20 V), reduction of gate oxide film reliability is feared. According to the present embodiment, however, when the gate voltage lowers, current flows via the diode 12 to suppress the voltage lowering (V1 + V3) below the negative power supply 3 of the gate drive circuit, so that gate oxide film reliability can be secured. Therefore, though, for example, a Schottky barrier diode with a small forward voltage (V3) is preferably used as the diode 12, a Zener diode or PN diode may alternatively be used.

Referring to Equations 1 and 2, to suppress gate voltage variations (rising and lowering), it is also effective to reduce the potential difference (V1) across the gate wiring 1 and, therefore, it is desirable to reduce the parasitic inductance (Lg) of the gate wiring 1. Lg can be reduced, for example, by minimizing the gate wiring length or by adopting a laminated busbar structure so as to cause magnetic fields generated by gate current to effectively cancel each other out.

Third Embodiment

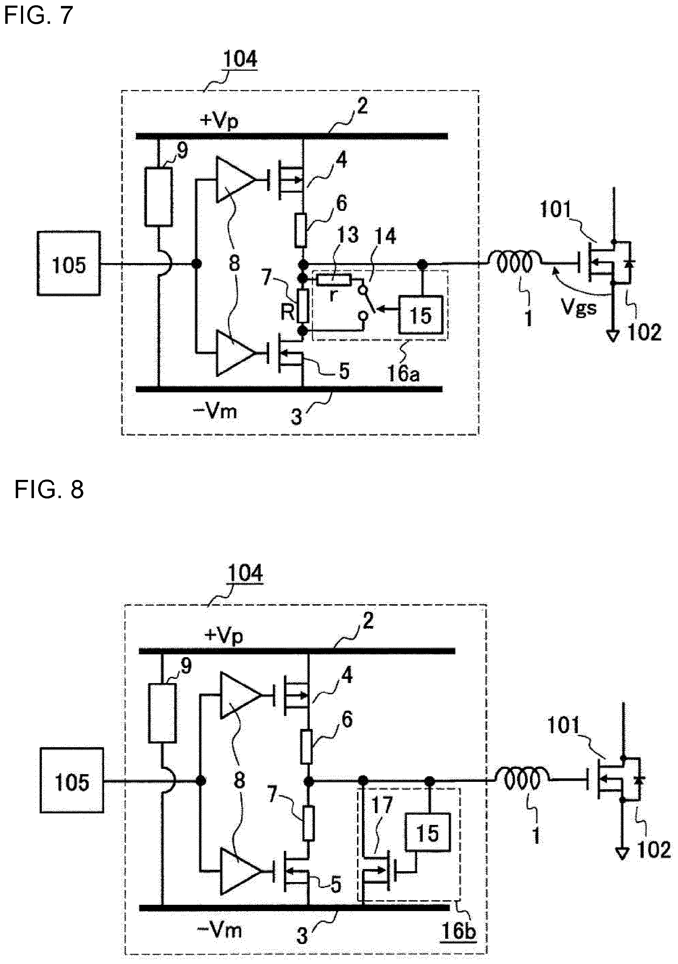

Fig. 7 shows a gate drive circuit configuration according to the third embodiment. The third embodiment differs from the second embodiment in which the diode 12 is used as a means of connecting the gate potential to the negative power supply of the gate drive circuit in that an impedance reduction circuit 16a is used. In the following, the third embodiment will be described centering on its differences from the first and second embodiments.

The impedance reduction circuit 16a includes a parallel resistor 13, an analog switch 14 and a gate-off determination unit 15. The parallel resistor 13 is connected in parallel, via the analog switch 14, to the off-side gate resistor 7. The gate-off determination unit 15 is connected between the output part of the gate drive circuit 104 and the analog switch 14.

The gate-off determination unit 15 monitors the gate-source voltage (Vgs) and detects an off-state of the semiconductor device 101 based on the value of Vgs. When the gate-off determination unit 15 determines that the semiconductor device 101 is in an off state, the analog switch 14 is closed and the off-side gate resistor 7 (resistance R) and the parallel resistor 13 (resistance r) are connected in parallel. When the two resistors are connected in parallel, the resistor resistance decreases from R to R/(1 + R/r) (<R). Therefore, when the gate potential lowers while the semiconductor device 101 is off, the output part of the gate drive circuit 104 is connected with a low impedance to the negative power supply 3 of the gate drive circuit, so that gate voltage variation (lowering) can be suppressed.

Whereas, in the second embodiment, the effect of rectification by the diode 12 generates an effect of suppressing gate voltage variations only when the voltage lowers, the present embodiment is superior in that, with the impedance reduction circuit 16a having bidirectionality, effects of suppressing gate voltage variations can be realized against both voltage lowering and rising. When the magnitude of rising of the gate voltage is suppressed, the potential difference margin allowable before the gate-source voltage of the semiconductor device 101 rises up to the threshold voltage (Vth) while the semiconductor device 101 is off is enlarged, so that occurrence of an erroneous on-state can be prevented.

Fourth Embodiment

Fig. 8 shows a gate drive circuit configuration according to the fourth embodiment. The fourth embodiment is different in that it uses an impedance reduction circuit including, not an analog switch, but a MOSFET. In the following, the fourth embodiment will be described centering on its differences from the first to third embodiments.

An impedance reduction circuit 16b includes a voltage clamping MOSFET 17 and a gate-off determination unit 15. The voltage clamping MOSFET 17 is connected between the output part of the gate drive circuit 104 and the negative power supply 3 of the gate drive circuit. The gate-off determination unit 15 is connected between the output part of the gate drive circuit 104 and the voltage clamping MOSFET 17.

When the gate-off determination unit 15 determines that the semiconductor device 101 is in an off state, it turns the voltage clamping MOSFET 17 on and causes the output part of the gate drive circuit 104 and the negative power supply 3 of the gate drive circuit to be short-circuited. Therefore, when the gate potential lowers while the semiconductor device 101 is off, the output part of the gate drive circuit 104 is connected, with an extremely low impedance, to the negative power supply 3 of the gate drive circuit, so that gate voltage variation (lowering) can be effectively suppressed.

The present embodiment, in which the impedance component present between the output part of the gate drive circuit 104 and the negative power supply 3 of the gate drive circuit is small (for example, several tens of mΩ) being made up of only the on resistance of the voltage clamping MOSFET 17, is advantageous compared with the third embodiment, in that, the gate voltage variations (lowering and rising) can be more effectively suppressed.

List of Reference Signs

| 1:  | gate wiring |
| 2:  | negative power supply of gate drive circuit |
| 3   | positive power supply of gate drive circuit |
| 4   | P-type MOSFET |
| 5   | N-type MOSFET |
| 6   | on-side gate resistor |
| 7   | off-side gate resistor |
| 8   | drive control device |
| 9   | power generation unit |
| 10  | NPN transistor |
| 11  | PNP transistor |

12      diode
13      parallel resistor
14      analog switch
15      gate-off determination unit
16a     impedance reduction circuit
16b     impedance reduction circuit
17      voltage clamping MOSFET
91:     rated voltage (upper limit)
92      positive supply voltage
93      negative supply voltage
94      rated voltage (lower limit)
100     power unit
100     voltage-driven semiconductor device (IGBT, MOSFET, etc.)
102     freewheel diode
103     filter capacitor
104     gate drive circuit
105     command logic unit
106     motor
107     overhead contact line
108     power collector
109     plural breaker
110     filter reactor
110     wheel
112     rail

**Claims**

1. A gate drive circuit for driving a voltage-driven semiconductor device using SiC, the gate drive circuit being configured including a P-type MOSFET and an N-type MOSFET mutually connected in series, the N-type MOSFET being connected directly to a negative power supply, wherein the P-type MOSFET and the N-type MOSFET are complementarily turned on/off so as to cause an output stage provided between the P-type MOSFET and the N-type MOSFET to be negatively biased while the semiconductor device is off.

2. The gate drive circuit according to claim 1, including a voltage keeping means for keeping the output stage negatively biased while the semiconductor device is off.

3. The gate drive circuit according to claim 2, wherein the voltage keeping means includes a diode connected, in parallel to the N-type MOSFET, between the output part and the negative power supply.

4. The gate drive circuit according to claim 3, wherein the diode is a Schottky barrier diode, a Zener diode, or a PN diode.

5. The gate drive circuit according to claim 2, wherein the voltage keeping means includes a parallel resistor parallel-connected to an off-side gate resistor provided between the output stage and the N-type MOSFET, a switch series-connected to the parallel resistor, and a determination unit that turns the switch on when the semiconductor device is in an off state.

6. The gate drive circuit according to claim 2, wherein the voltage keeping means includes a MOSFET connected, in parallel to the N-type MOSFET, between the output stage and the negative power supply and a determination unit that causes the MOSFET to be short-circuited when the semiconductor device is in an off state.

7. The gate drive circuit according to one of claims 1 to 6, wherein the semiconductor device is a normally-off semiconductor device.

8. The gate drive circuit according to one of claims 1 to 7, wherein an insulated power transformer or an insulated DC-DC converter is used for voltage generation for the negative power supply.

**9.** A three-phase AC inverter mounted with the gate drive circuit according to one of claims 1 to 8.

**10.** A gate drive method for a voltage-driven semiconductor device using SiC,
wherein, by complementarily turning on/off a P-type MOSFET and an N-type MOSFET which is directly connected to a negative power supply, an output stage between the mutually series-connected P-type MOSFET and N-type MOSFET is negatively biased while the semiconductor device is off.

**11.** The gate drive method according to claim 10,
wherein a voltage keeping means keeps, while the semiconductor device is off, the output stage negatively biased.

**12.** The gate drive method according to claim 11,
wherein the voltage keeping means includes a diode connected, in parallel to the N-type MOSFET, between the output part and the negative power supply.

**13.** The gate drive method according to claim 12,
wherein the diode is a Schottky barrier diode, a Zener diode, or a PN diode.

**14.** The gate drive method according to claim 11,
wherein, when the semiconductor device is in an off state, a switch series-connected to a parallel resistor which is parallel-connected to an off-side gate resistor provided between the output stage and the N-type MOSFET is turned on.

**15.** The gate drive method according to claim 11, wherein, when the semiconductor device is in an off state, a MOSFET connected, in parallel to the N-type MOSFET, between the output stage and the negative power supply is short-circuited.

**16.** The gate drive method according to one of claims 11 to 15, wherein the semiconductor device is a normally-off semiconductor device.

**17.** The gate drive method according to one of claims 11 to 16,
wherein an insulated power transformer or an insulated DC-DC converter is used for voltage generation for the negative power supply.

FIG. 1

**FIG. 2**

**FIG. 3**

FIG. 4

FIG. 5

FIG. 6

FIG. 7

FIG. 8

FIG. 9

## INTERNATIONAL SEARCH REPORT

| International application No. |
| --- |
| PCT/JP2019/009651 |

| A. CLASSIFICATION OF SUBJECT MATTER |
| --- |
| Int.Cl. H02M1/08(2006.01)i, H03K17/08(2006.01)i, H03K17/0812(2006.01)i |

According to International Patent Classification (IPC) or to both national classification and IPC

| B. FIELDS SEARCHED |
| --- |

Minimum documentation searched (classification system followed by classification symbols)
Int.Cl. H02M1/08, H03K17/08, H03K17/0812

Documentation searched other than minimum documentation to the extent that such documents are included in the fields searched

| | |
| --- | --- |
| Published examined utility model applications of Japan | 1922-1996 |
| Published unexamined utility model applications of Japan | 1971-2019 |
| Registered utility model specifications of Japan | 1996-2019 |
| Published registered utility model applications of Japan | 1994-2019 |

Electronic data base consulted during the international search (name of data base and, where practicable, search terms used)

| C. DOCUMENTS CONSIDERED TO BE RELEVANT |
| --- |

| Category* | Citation of document, with indication, where appropriate, of the relevant passages | Relevant to claim No. |
| --- | --- | --- |
| Y <br> A | WO 2015/182658 A1 (MITSUBISHI ELECTRIC CORPORATION) 03 December 2015, paragraphs [0011]-[0038], fig. 1-3, 5 <br> & US 2017/0040992 A1, paragraphs [0024]-[0051], fig. 1-3, 5 & EP 3151402 A1 & CN 106104993 A | 1-4, 7-13, 16-17 <br> 5-6, 14-15 |
| Y <br> A | JP 2016-123199 A (PANASONIC INTELLECTUAL PROPERTY MANAGEMENT CO., LTD.) 07 July 2016, paragraphs [0026], [0079], [0082], [0108]-[0112], fig. 5, 9 (Family: none) | 1-4, 7-13, 16-17 <br> 5-6, 14-15 |

☒ Further documents are listed in the continuation of Box C. ☐ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 02.04.2019 | 16.04.2019 |

| Name and mailing address of the ISA/ <br> Japan Patent Office <br> 3-4-3, Kasumigaseki, Chiyoda-ku, <br> Tokyo 100-8915, Japan | Authorized officer |
| --- | --- |
| | Telephone No. |

Form PCT/ISA/210 (second sheet) (January 2015)

**INTERNATIONAL SEARCH REPORT**

| International application No. |
| --- |
| PCT/JP2019/009651 |

C (Continuation). DOCUMENTS CONSIDERED TO BE RELEVANT

| Category* | Citation of document, with indication, where appropriate, of the relevant passages | Relevant to claim No. |
| --- | --- | --- |
| A | JP 2012-199763 A (SANKEN ELECTRIC CO., LTD.) 18 October 2012, entire text, all drawings (Family: none) | 1-17 |
| A | WO 2018/008398 A1 (MITSUBISHI ELECTRIC CORPORATION) 11 January 2018, entire text, all drawings (Family: none) | 1-17 |

Form PCT/ISA/210 (continuation of second sheet) (January 2015)

**EP 3 787 164 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012009962 A
- JP 2014057491 A